(19) **Europäisches Patentamt / European Patent Office / Office européen des brevets**

(11) **EP 3 552 032 B1**

(12) **FASCICULE DE BREVET EUROPEEN**

(45) Date de publication et mention de la délivrance du brevet:
**29.03.2023 Bulletin 2023/13**

(21) Numéro de dépôt: **17804207.3**

(22) Date de dépôt: **29.11.2017**

(51) Classification Internationale des Brevets (IPC):
**G01R 31/11** *(2006.01)*    **G06F 17/15** *(2006.01)*

(52) Classification Coopérative des Brevets (CPC):
**G01R 31/11;** G06F 17/15

(86) Numéro de dépôt international:
**PCT/EP2017/080767**

(87) Numéro de publication internationale:
**WO 2018/108526 (21.06.2018 Gazette 2018/25)**

(54) **SYSTEME DE DETECTION DE DEFAUTS DANS UNE LIGNE DE TRANSMISSION, PAR UTILISATION D'UN SIGNAL COMPLEXE**

SYSTEM ZUR ERKENNUNG VON DEFEKTEN IN EINER ÜBERTRAGUNGSLEITUNG UNTER VERWENDUNG EINES KOMPLEXEN SIGNALS

SYSTEM FOR DETECTING FAULTS IN A TRANSMISSION LINE BY USING A COMPLEX SIGNAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.12.2016 FR 1662308**

(43) Date de publication de la demande:
**16.10.2019 Bulletin 2019/42**

(73) Titulaire: **Commissariat à l'Énergie Atomique et aux Énergies Alternatives**
**75015 Paris (FR)**

(72) Inventeurs:
• **CABANILLAS, Esteban**
**91400 Orsay (FR)**
• **LAYER, Christophe**
**75015 Paris (FR)**

(74) Mandataire: **Atout PI Laplace**
**Immeuble "Visium"**
**22, avenue Aristide Briand**
**94117 Arcueil Cedex (FR)**

(56) Documents cités:
FR-A1- 3 012 617    US-A1- 2011 035 168
US-A1- 2016 139 194    US-A1- 2016 266 194

• WAFA BEN HASSEN ET AL: "OMTDR using BER estimation for ambiguities cancellation in ramified networks diagnosis", INTELLIGENT SENSORS, SENSOR NETWORKS AND INFORMATION PROCESSING, 2013 IEEE EIGHTH INTERNATIONAL CONFERENCE ON, IEEE, 2 avril 2013 (2013-04-02), pages 414-419, XP032422571, DOI: 10.1109/ISSNIP.2013.6529826 ISBN: 978-1-4673-5499-8
• Lincoln Laboratory ET AL: "Systolic Architecture-1 PAJ 9/29/2004 A Systolic FFT Architecture for Real Time FPGA Systems", , 29 septembre 2004 (2004-09-29), XP055405591, Extrait de l'Internet: URL:https://crd.lbl.gov/assets/pubs_presos/systolicfft-presentation.pdf [extrait le 2017-09-12]

**Description**

L'invention concerne le domaine de l'analyse de défauts impactant des lignes de transmission, tels que des câbles électriques et plus particulièrement des câbles de communication.

Plus précisément, l'invention concerne le domaine particulier de la réflectométrie appliquée au diagnostic filaire qui englobe le domaine de la détection, la localisation et la caractérisation de défauts dans des lignes de transmission simples ou des réseaux filaires complexes.

Les méthodes de réflectométrie connues fonctionnent selon le procédé suivant. Un signal de référence maitrisé, par exemple un signal impulsionnel ou encore un signal multi-porteuses, est injecté à une extrémité du câble à tester. Plus généralement, le signal de référence utilisé est choisi en fonction de ses propriétés d'intercorrélation. Le signal se propage le long du câble et se réfléchit sur les singularités qu'il comporte.

Une singularité dans un câble correspond à une rupture des conditions de propagation du signal dans ce câble. Elle résulte le plus souvent d'un défaut qui modifie localement l'impédance caractéristique du câble en provoquant une discontinuité dans ses paramètres linéiques. Un défaut peut résulter de tout type de dégradation locale d'un câble, d'un pincement, d'un frottement ou d'une dégradation superficielle de la gaine du câble.

Le signal réfléchi est rétro-propagé jusqu'au point d'injection, puis est analysé par le système de réflectométrie. Le retard entre le signal injecté et le signal réfléchi permet de localiser une singularité, correspondant à un défaut électrique, dans le câble. Un défaut peut résulter d'un court circuit, d'un circuit ouvert ou encore d'une dégradation locale du câble voire d'un simple pincement du câble.

La réflectométrie est basée sur le principe d'une mesure d'un écho du signal injecté sur une singularité du câble analysé. Cependant, il existe des zones du câble, appelées zones aveugles, pour lesquelles un écho ne pourra pas être mesuré. Ces zones dépendent de la longueur d'onde du signal, donc de sa fréquence, de la vitesse de propagation du signal, de la fréquence d'échantillonnage du signal mesuré et de la distance entre le point d'injection du signal et le point où se situe la singularité. Si un défaut apparait dans une zone aveugle, il n'est donc pas possible de détecter sa présence en utilisant une méthode de réflectométrie classique.

Par ailleurs, la détection de défauts avec précision nécessite d'utiliser un signal à haute fréquence afin que la longueur d'onde du signal injecté coïncide avec les dimensions physiques des défauts dans le câble. Or, les convertisseurs analogiques-numériques qui permettent d'injecter et de mesurer un signal à haute fréquence sont couteux. En outre les canaux de transmission correspondant aux différentes technologies de câbles visées par les applications de réflectométrie, sont le plus souvent très sélectifs en fréquence et ne permettent donc pas une observation et un diagnostic large bande. Certaines bandes de fréquences peuvent être sensiblement atténuées ou perturbées ce qui peut rendre inexploitable le signal mesuré par le système de réflectométrie ou en tout cas complexifier l'identification des défauts éventuels.

Un autre problème concerne également la compatibilité d'un système de réflectométrie avec un câble ou un réseau de câbles de communication. Pour de tels câbles, le signal de réflectométrie injecté peut venir perturber les signaux de communication également transmis via ces câbles ce qui rend impossible un diagnostic pendant que le réseau de communication est en fonctionnement. Certaines bandes de fréquences ne peuvent pas être utilisées pour le diagnostic par réflectométrie car elles sont réservées à la transmission de données.

Les méthodes et systèmes de réflectométrie pour mesurer l'état de santé d'un câble et caractériser la présence d'éventuels défauts ont fait l'objet de nombreuses publications.

Sans être exhaustif, on peut citer les demandes de brevet internationales WO2014/144436 et WO2015/145068 qui décrivent des systèmes de réflectométrie fréquentielle basés respectivement sur des signaux à étalement de spectre et des signaux à multi-porteuses orthogonales (OFDM).

Ces systèmes ne résolvent pas les problèmes précités car ils fonctionnent le plus souvent à fréquence fixe, ne permettent pas d'identifier des défauts présents dans une zone aveugle ni de faire fonctionner le système de réflectométrie sur un réseau de câbles de communication en fonctionnement sans perturber les communications.

On connait par ailleurs les solutions décrites dans les documents US 2016/266194, US 2016/139194 ainsi que dans la publication scientifique de Wafa Ben Hassen et al, « OMTDR using BER estimation for ambiguites cancellation in ramified networks diagnosis », Intelligent Sensors, Sensor Networks and Information Processing, 2013, IEEE.

L'invention permet de résoudre le problème des zones aveugles en utilisant un signal de réflectométrie complexe modulé en quadrature et en exploitant conjointement les réflectogrammes obtenus pour la voie réelle et la voie imaginaire du signal mesuré.

L'invention permet également de réaliser une analyse fréquentielle large bande d'un câble par l'utilisation d'une transposition en fréquence du signal injecté dans le câble.

L'utilisation d'un signal complexe permet aussi un fonctionnement simultané d'une communication de données via le câble à analyser et d'une analyse des défauts du câble par réflectométrie avec un débit de transmission de données doublé par rapport à un signal réel.

L'invention a ainsi pour objet un système de réflectométrie pour l'analyse de défauts dans une ligne de transmission dans laquelle un signal complexe généré puis modulé a été injecté, ledit système comprenant :

- un moyen de mesure du signal complexe modulé se propageant dans la ligne de transmission,
- un démodulateur du signal mesuré apte à produire un signal complexe démodulé,
- un corrélateur complexe configuré pour corréler le signal complexe démodulé avec une copie du signal complexe généré, pour produire un premier réflectogramme temporel correspondant à la partie réelle de la corrélation complexe et un second réflectogramme temporel correspondant à la partie imaginaire de la corrélation complexe,
- un module d'analyse conjointe du premier réflectogramme temporel et du second réflectogramme temporel pour identifier la présence de défauts dans la ligne de transmission.

Selon un aspect particulier de l'invention, le module d'analyse est configuré pour déterminer un réflectogramme temporel unique à partir du module de la corrélation complexe.

Selon une variante de réalisation, le système selon l'invention comprend en outre un détecteur de phase configuré pour mesurer la phase de la corrélation complexe à l'abscisse temporelle 0 et un correcteur de phase configuré pour corriger le signal complexe démodulé de la phase mesurée par le détecteur de phase.

Selon une variante de réalisation, le système selon l'invention comprend en outre un générateur de signal complexe, un modulateur apte à moduler le signal complexe pour produire un signal modulé et un moyen pour injecter le signal modulé en un point de la ligne de transmission.

Selon une variante de réalisation, le système selon l'invention comprend en outre :

- un oscillateur local apte à contrôler la fréquence du modulateur pour réaliser une transposition en fréquence du signal et un oscillateur local apte à contrôler la fréquence du démodulateur pour réaliser une transposition du signal en bande de base,
- un organe de contrôle apte à contrôler la valeur de la fréquence à laquelle le signal est transposé.

Selon un aspect particulier de l'invention, l'organe de contrôle est configuré pour déterminer la valeur de la fréquence de transposition du signal en fonction d'au moins une analyse du premier réflectogramme temporel et/ou du second réflectogramme temporel.

Selon un aspect particulier de l'invention, l'analyse du premier réflectogramme temporel et/ou du second réflectogramme temporel porte sur une mesure de l'atténuation du signal mesuré.

Selon un aspect particulier de l'invention, le signal complexe généré est un signal fréquentiel à multi-porteuses, ledit système comprenant en outre à cet effet un module de transformée de Fourier inverse appliqué au signal complexe généré et un module de transformée de Fourier appliqué au signal complexe démodulé.

Selon un aspect particulier de l'invention, le corrélateur complexe comprend un corrélateur du signal fréquentiel généré avec le signal fréquentiel démodulé et une transformée de Fourier inverse appliquée au résultat de la corrélation.

Selon un aspect particulier de l'invention, le générateur de signal complexe comprend une interface pour recevoir des données numériques à transmettre et un modulateur pour convertir les données numériques en symboles complexes, ledit système comprenant en outre un récepteur pour convertir le signal démodulé complexe en données numériques reçues.

Selon une variante de réalisation, le système selon l'invention comprend en outre un encodeur des données numériques à transmettre et un décodeur des données numériques reçues, l'organe de contrôle étant configuré pour déterminer le taux de codage de l'encodeur et du décodeur.

Selon une variante de réalisation, le système selon l'invention comprend en outre un module de calcul du taux d'erreurs entre les données numériques décodées et les données numériques à transmettre, l'organe de contrôle étant configuré pour déterminer la valeur de la fréquence de transposition du signal et/ou le taux de codage en fonction d'au moins le taux d'erreurs calculé.

D'autres caractéristiques et avantages de la présente invention apparaîtront mieux à la lecture de la description qui suit en relation aux dessins annexés qui représentent :

- La figure 1, un schéma d'un système de détection de défauts dans une ligne de transmission selon l'art antérieur,
- La figure 2, un schéma d'un système de détection de défauts dans une ligne de transmission selon l'invention,

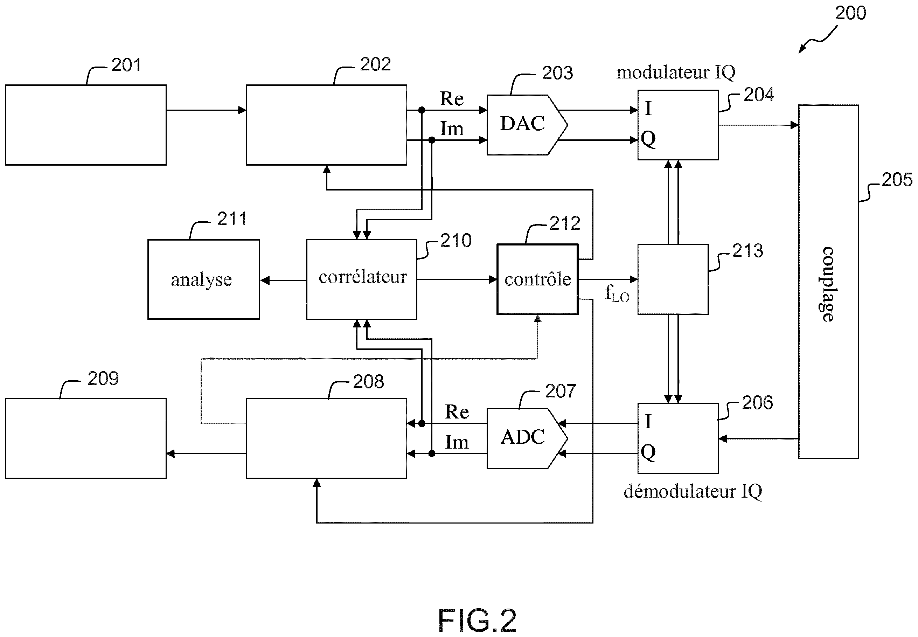

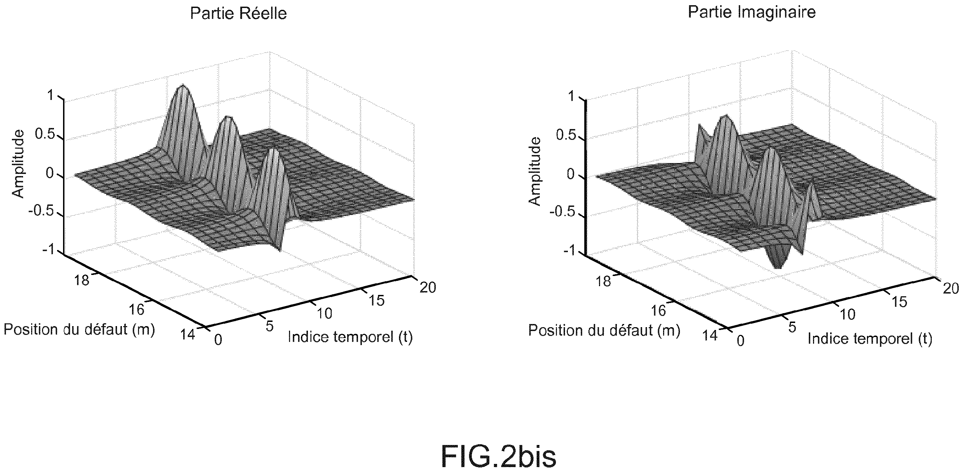

- La figure 2bis, deux exemples de réflectogrammes illustrant l'apport de l'utilisation d'un signal de réflectométrie complexe,

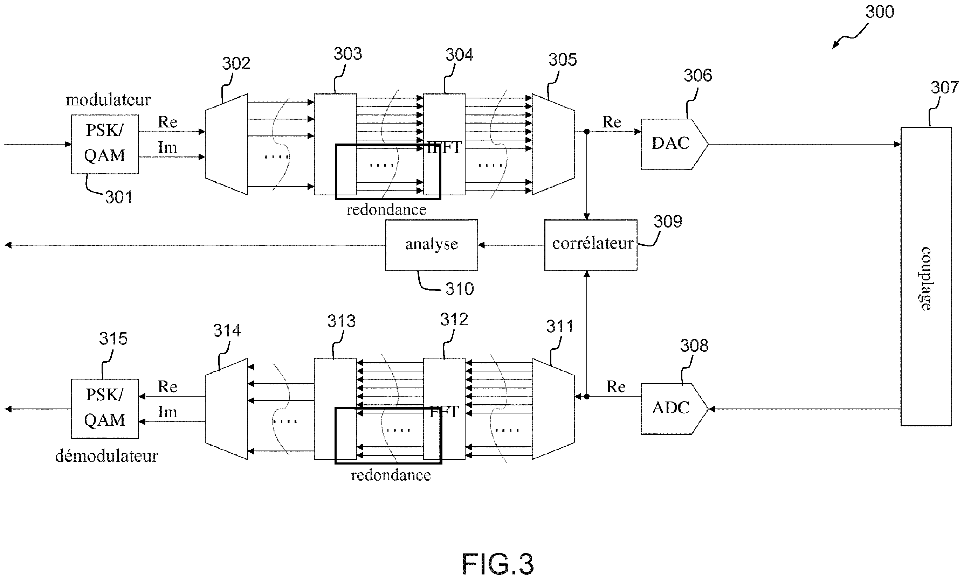

- La figure 3, un schéma d'un système de détection de défauts utilisant un signal de type OMTDR,

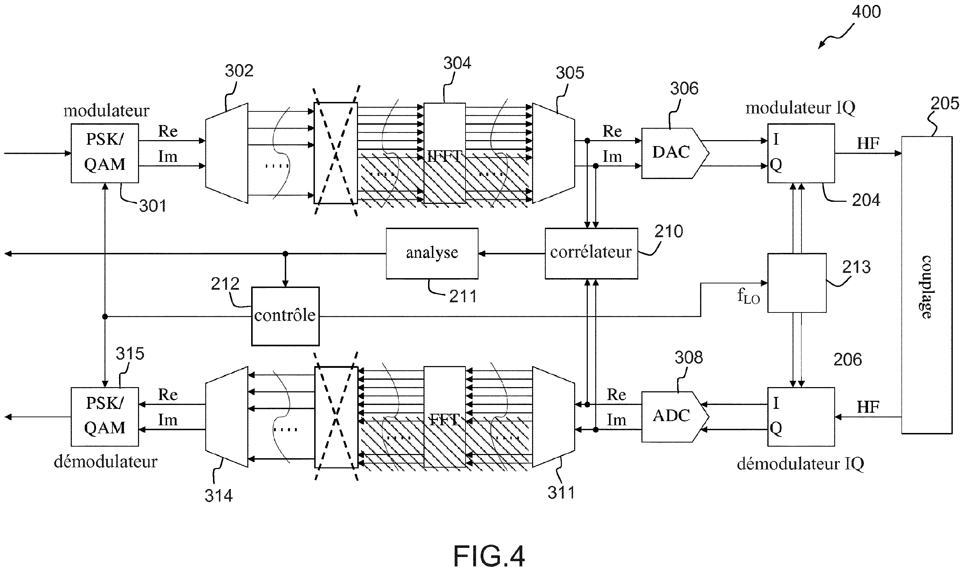

- La figure 4, un schéma d'un système de détection de défauts dans une ligne de transmission selon un mode particulier de l'invention,

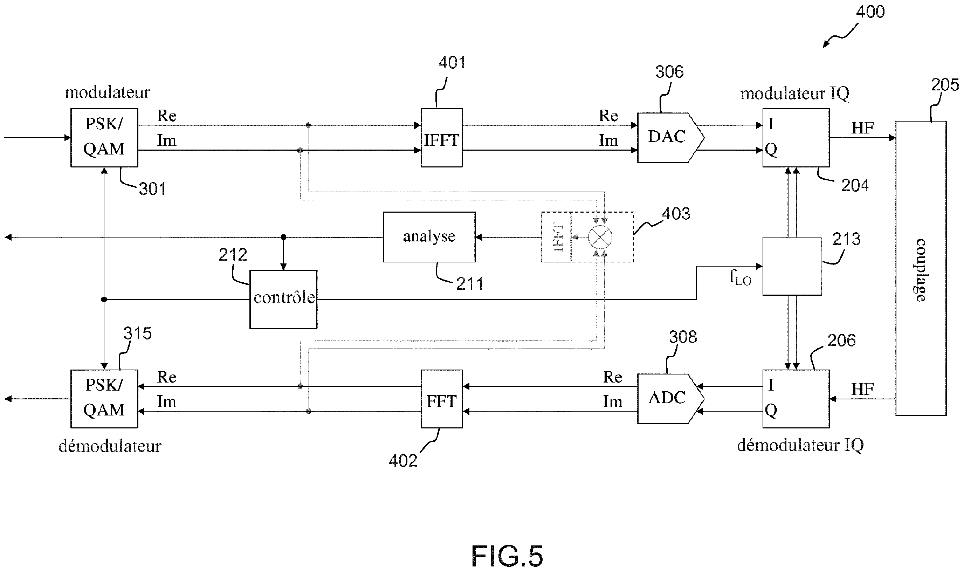

- La figure 5, le schéma de la figure 4 dans lequel le module de corrélation est explicité,

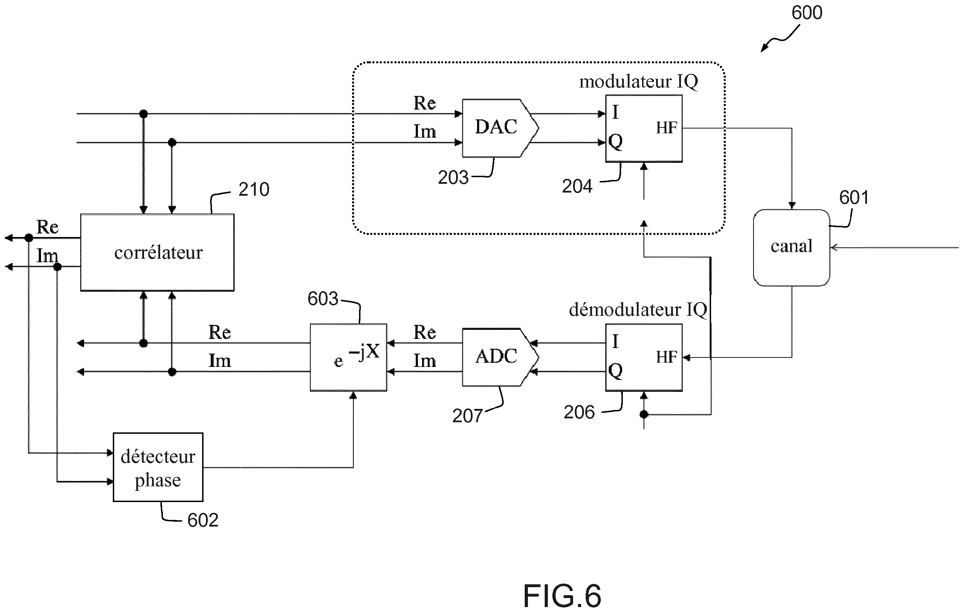

- La figure 6, un schéma d'un système de détection de défauts selon une variante de réalisation de l'invention.

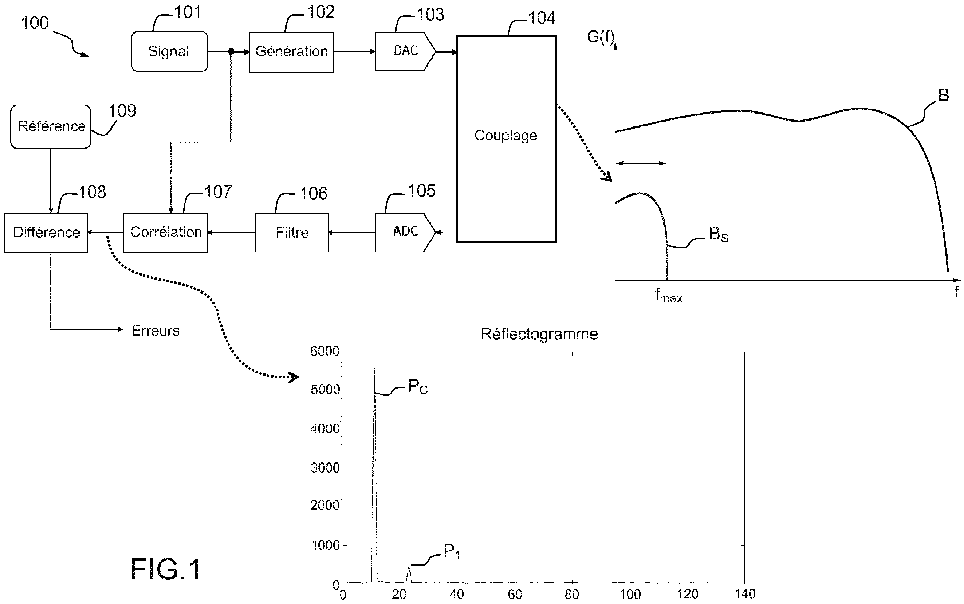

La figure 1 schématise un système 100 de détection de défauts dans une ligne de transmission, par réflectométrie, selon un principe connu de l'art antérieur.

Le système 100 comporte principalement un générateur 102 d'un signal de référence à partir des paramètres 101 du signal. Le signal de référence peut être temporel ou fréquentiel. Il peut s'agir d'une simple impulsion temporelle ou d'un signal plus élaboré dans la mesure où celui-ci présente de bonnes propriétés d'autocorrélation, c'est-à-dire que le résultat d'un calcul d'autocorrélation appliqué à ce signal donne un pic d'amplitude significatif qu'il est possible d'identifier et de détecter. Par exemple, le signal utilisé peut être du type OMTDR (Orthogonal Multi-tone Time Domain Reflectometry) ou MCTDR (MultiCarrier Time Domain Reflectometry). Un convertisseur numérique-analogique 103 permet de convertir le signal numérique en un signal analogique qui est ensuite injecté en un point de la ligne de transmission (non représentée à la figure 1) via un coupleur 104.

Le système 100 comporte ensuite une partie mesure qui comprend un coupleur 104 (identique au précédent ou distinct) pour mesurer, en un point de la ligne, le signal réfléchi et rétro-propagé dans la ligne de transmission. Le signal analogique mesuré est converti numériquement via un convertisseur analogique numérique 105. Le signal numérique peut être filtré 106 ou moyenné afin de limiter l'influence du bruit de mesure, puis un corrélateur 107 est en charge de réaliser une corrélation entre le signal mesuré et le signal généré, pour différents décalages temporels, afin de produire un réflectogramme temporel. Un exemple de réflectogramme temporel est donné sur le bas de la figure 1. Il comporte un certain nombre de pics d'amplitude qui traduisent des discontinuités d'impédance dans la ligne de transmission. Les abscisses temporelles des pics sur le réflectogramme correspondent à des positions dans la ligne de transmission. La relation de conversion entre abscisse temporelle t et position d est donnée par la relation d=V.t où V est la vitesse de propagation du signal dans la ligne. Le réflectogramme obtenu peut être corrigé 108 en calculant sa différence par rapport à un réflectogramme de référence 109. Sur le réflectogramme donné en exemple à la figure 1, on observe un premier pic $P_0$ correspondant à la discontinuité d'impédance au point d'injection du signal puis un second pic $P_1$ qui correspond à une autre discontinuité d'impédance qui peut découler d'un défaut électrique sur la ligne. Ainsi, par analyse du réflectogramme, on peut en déduire la présence et la localisation de défauts dans une ligne de transmission.

Sur la droite de la figure 1, on a représenté un exemple de réponse en fréquence B d'un canal de propagation associé à une ligne de transmission, par exemple un câble de communication. Sur le même diagramme, on a représenté l'occupation spectrale $B_s$ d'un signal typique de réflectométrie. Ce diagramme illustre le fait que, le plus souvent, la bande de fréquence disponible dans le câble est beaucoup plus large que celle du signal injecté, notamment du fait des limitations du convertisseur numérique-analogique 103.

Un objectif de l'invention est de proposer un système qui soit plus flexible au niveau du paramétrage de l'occupation spectrale du signal de réflectométrie injecté dans le câble à analyser. D'une part, un fonctionnement à haute fréquence permet de mieux caractériser des défauts de petite taille et d'autre part, certaines bandes de fréquences peuvent être perturbées par des interférences, atténuées du fait de la sélectivité en fréquence de la réponse fréquentielle du câble ou encore réservées à d'autres applications (par exemple pour la communication de données).

A cet effet, le système 200 schématisé à la figure 2 est proposé, selon l'invention. Une différence principale entre le système 200 selon l'invention et un système 100 selon l'art antérieur réside dans l'exploitation d'un signal de réflectométrie complexe et non plus un signal réel comme cela est le cas habituellement. Ainsi, un signal complexe est généré 201,202 et délivré en entrée d'un convertisseur numérique-analogique 203 sous la forme de deux voies parallèles, une voie en phase I et une voie en quadrature de phase Q. Le convertisseur 203 produit ainsi deux signaux analogiques qui sont fournis à un modulateur IQ 204 qui réalise une modulation de phase pour produire un signal analogique modulé en phase. Le signal modulé est injecté dans la ligne de transmission au moyen d'un coupleur 205 ou tout autre dispositif équivalent.

Une mesure du signal rétro-propagé dans la ligne de transmission est réalisée en captant le signal via le même coupleur 205 ou un second coupleur différent du premier coupleur 205 puis est fourni en entrée d'un démodulateur IQ 206 qui réalise une démodulation de phase du signal pour produire deux signaux analogiques correspondants respectivement à une voie en phase I et une voie en quadrature de phase Q. Les deux signaux sont ensuite numérisés via un convertisseur analogique-numérique 207.

Le système 200 comprend également un corrélateur 210 complexe pour réaliser une corrélation, à différents instants temporels, entre le signal complexe mesuré en sortie du convertisseur analogique numérique 207 et le signal complexe généré en entrée du convertisseur numérique analogique 203. Ainsi, le corrélateur 210 fournit deux réflectogrammes distincts, un premier réflectogramme correspondant à la voie réelle (I) du signal complexe et un second réflectogramme correspondant à la voie imaginaire (Q) du signal complexe. Autrement dit, le premier réflectogramme correspond à la partie réelle de la corrélation complexe tandis que le second réflectogramme correspond à la partie imaginaire de la corrélation complexe. Les deux réflectogrammes sont exploités par un module d'analyse 211 pour détecter et caractériser la présence de défauts éventuels.

L'utilisation d'un signal complexe associée à l'exploitation de deux réflectogrammes distincts permet d'améliorer la détection de défauts notamment en résolvant le problème des zones aveugles.

Comme expliqué précédemment, il existe des zones qu'on appelle zones aveugles, correspondant à certaines valeurs de distance entre le point d'injection du signal et le défaut, pour lesquelles l'écho du signal sur le défaut n'est pas détecté. Ce problème est bien connu dans le domaine de la réflectométrie et dépend de différents paramètres dont la longueur du câble, la longueur d'onde du signal, sa fréquence d'échantillonnage et la vitesse de propagation de l'onde dans le câble.

Ainsi, les systèmes usuels de réflectométrie tels que celui décrit à la figure 1, qui n'exploitent qu'un signal réel, ne permettent pas de détecter la présence d'un défaut s'il est situé dans une zone aveugle.

Lorsqu'on utilise un signal complexe, tel que proposé via le système de la figure 2, les zones aveugles pour la partie réelle du signal ne sont pas situées aux mêmes distances que les zones aveugles pour la partie imaginaire du signal. Précisément, les zones aveugles qui concernent la partie réelle du signal correspondent à des zones où la partie imaginaire du signal est maximisée. Ainsi, en exploitant conjointement un premier réflectogramme correspondant à la partie réelle du signal et un second réflectogramme correspondant à la partie imaginaire du signal, on améliore la détection et la localisation de défauts puisqu'il est alors possible de caractériser un défaut quelle que soit sa position sur le câble.

Ce principe est illustré sur la figure 2bis qui représente deux exemples de réflectogrammes correspondant respectivement à la partie réelle de la corrélation complexe 210 (sur la gauche de la figure) et à sa partie imaginaire (sur la droite de la figure). Les diagrammes de la figure 2bis illustrent les résultats obtenus en faisant varier la position d'un défaut le long d'un câble. Chaque diagramme représente l'amplitude du réflectogramme en fonction d'une part de l'abscisse temporelle et d'autre part de la position du défaut par rapport au point d'injection (exprimé en mètres). Le pic d'amplitude observé dans un réflectogramme donne la position correspondante du défaut détecté. Cette position est obtenue en convertissant l'abscisse temporelle du pic dans le domaine des distances (via la vitesse de propagation du signal).

Sur chacun des deux réflectogrammes, on peut observer que pour certaines valeurs de la distance entre le défaut et le point d'injection du signal, aucun pic d'amplitude n'est observé dans le réflectogramme. Ce phénomène se reproduit périodiquement lorsqu'on fait varier la position du défaut le long du câble. Les zones pour lesquelles aucun pic n'est observé dans le réflectogramme correspondent aux zones dites aveugles.

Cependant, on remarque également que les zones aveugles ne sont pas situées aux mêmes positions pour le réflectogramme correspondant à la partie réelle du signal et pour le réflectogramme correspondant à la partie imaginaire du signal.

Ainsi, en exploitant les deux réflectogrammes, il n'existe aucune position de défaut pour laquelle il n'est pas possible d'identifier un pic d'amplitude dans au moins un des deux réflectogrammes.

L'analyse 211 des deux réflectogrammes peut consister à observer séparément les deux réflectogrammes, par exemple en fixant un seuil de détection pour chaque réflectogramme et en retenant les pics d'amplitude observés, qui dépassent ce seuil, dans l'un ou l'autre des deux réflectogrammes.

L'analyse 211 peut également consister à calculer un unique réflectogramme à partir des deux réflectogrammes fournis par le corrélateur 210, par exemple en calculant le module de la corrélation complexe ou le module au carré de la corrélation complexe. Ainsi, un pic d'amplitude correspondant à un défaut sera présent dans le module de la corrélation complexe quelle que soit la position du défaut.

Sur le schéma de la figure 2, on a représenté un système 200 unique qui comprend à la fois les éléments dédiés à la génération et à l'injection du signal dans le câble et les éléments dédiés à la mesure du signal réfléchi, au calcul et à l'analyse du réflectogramme.

Dans une variante de réalisation non représentée à la figure 2, le système 200 peut être décomposé en deux systèmes distincts, un premier système dédié à la génération et à l'injection du signal en un point quelconque du câble (par exemple à une extrémité) et un second système dédié à la mesure du signal réfléchi en un point quelconque du câble, au calcul et à l'analyse du réflectogramme. Cette variante de réalisation est notamment avantageuse lorsque le point d'injection du signal et le point de mesure du signal réfléchi sont deux points distincts, par exemple lorsque le câble est de très grande longueur ou pour des réseaux de câbles complexes.

Le module d'analyse 211 peut restituer les résultats d'analyse à un utilisateur via une interface homme machine (non représentée), par exemple un écran ou toute autre interface. Les résultats d'analyse peuvent consister à fournir le ou les réflectogramme(s) calculé(s) ou à fournir directement la ou les position(s) du ou des défaut(s) identifié(s) ainsi que toute autre information concernant les défauts détectés.

Selon un mode de réalisation particulier de l'invention, le système 200 comporte également un organe de contrôle 212 couplé à un oscillateur local 213 qui agit sur le modulateur 204 pour réaliser une transposition du signal en fréquence avant son injection dans le câble. Réciproquement, l'oscillateur local 213 agit également sur le démodulateur 206 pour ramener le signal en bande de base après son acquisition. Bien qu'on ait représenté un seul oscillateur local 213 sur la figure 2, il peut exister deux oscillateurs locaux distincts associés respectivement au modulateur IQ 204 et au démodulateur IQ 206.

L'organe de contrôle 212 pilote l'oscillateur local en lui communiquant la valeur de la fréquence de transposition du signal.

Un avantage de ce mode de réalisation de l'invention est qu'il permet de transposer le signal dans les hautes fréquences du canal de propagation associé au câble à analyser. Un signal à haute fréquence présente une longueur d'onde faible qui permet de mieux caractériser les défauts de petite taille. Par ailleurs, l'organe de contrôle 212 peut déterminer la fréquence de transposition en fonction de différents paramètres.

La fréquence de transposition peut être sélectionnée de sorte à placer le signal dans une bande de fréquence autorisée pour l'analyse de défauts et à éviter toute bande de fréquence interdite car réservée à d'autres applications.

La fréquence de transposition peut aussi être sélectionnée de sorte à choisir la bande de fréquence du signal en fonction des paramètres du câble à analyser. En effet, la bande de fréquence d'un câble est généralement très sélective en fréquence et le choix de la fréquence du signal a un impact direct sur le réflectogramme mesuré et donc sur la précision de la caractérisation des défauts. Il est donc important de pouvoir optimiser la bande de fréquence du signal et de pouvoir la faire varier dynamiquement en fonction du type de câble analysé.

L'organe de contrôle 212 peut également déterminer la fréquence de transposition en fonction d'une analyse du réflectogramme fourni par le corrélateur 210. Plus précisément, l'organe de contrôle 212 peut analyser le niveau d'atténuation du signal sur le réflectogramme et en déduire une information sur le niveau de puissance du signal mesuré dans la bande de fréquence courante. Si le niveau de puissance est trop faible, cela signifie que la bande de fréquence sélectionnée est trop atténuée, dans ce cas l'organe de contrôle 212 peut sélectionner une autre bande de fréquence et donc une nouvelle fréquence de transposition.

D'autres critères d'analyse peuvent être utilisés en exploitant le réflectogramme pour, par exemple, déterminer si la bande de fréquence du signal est perturbée par des interférences ou si plus généralement le réflectogramme n'est pas exploitable et nécessite un changement de bande de fréquence. Ainsi, l'organe de contrôle peut modifier dynamiquement la fréquence de transposition si la bande de fréquence courante du signal est perturbée.

Le système 200 comprenant l'organe de contrôle 212 peut également être utilisé pour réaliser une reconstruction large bande en effectuant un balayage successif de toute la bande de fréquence du câble par sous-bandes. De cette manière, plusieurs réflectogrammes associés à plusieurs sous-bandes fréquentielles peuvent être déterminés et un réflectogramme global associé à la bande de fréquence totale du câble peut être obtenu in fine.

Selon un autre mode de réalisation de l'invention, le système 200 peut également comporter une partie 201,202 d'émission de données ainsi qu'une partie 208,209 de réception de données La transmission de données se fait via le signal de réflectométrie, permettant ainsi de concevoir un système 200 qui fonctionne à la fois en tant que système de communication et en tant que système d'analyse de défauts par réflectométrie ou par transférométrie. Un avantage de ce mode de réalisation est qu'il permet de faire fonctionner les deux systèmes simultanément sans qu'ils se perturbent réciproquement ou interfèrent l'un avec l'autre.

La partie émission du système comporte un générateur de données numériques 201 ou plus généralement une interface pour recevoir des données numériques depuis une application de communication. Elle comporte en outre un modulateur numérique 202 apte à convertir les données binaires en symboles complexes afin de fournir un signal numérique complexe au convertisseur 203. Le modulateur numérique 202 peut être un modulateur de phase PSK (Phase Shift Keying) ou un modulateur d'amplitude QAM (Quadrature Amplitude Modulation) ou tout autre modulateur ou codeur de symboles apte à convertir une séquence de bits en symboles numériques complexes appartenant à une constellation de symboles donnée.

Optionnellement, le modulateur numérique 202 peut aussi comporter un codeur canal ou codeur correcteur ou encodeur de données numériques qui vise à ajouter de la redondance aux bits à émettre afin de les protéger contre d'éventuelles perturbations causant des erreurs de transmission dans le canal de propagation.

La partie réception du système comporte un démodulateur numérique 208 qui effectue la conversion des symboles complexes du signal mesuré en bits ainsi qu'un récepteur de données 209 qui transmet les bits démodulés vers l'application destinatrice des données. Optionnellement, le démodulateur numérique 208 comporte un décodeur pour décoder les bits démodulés s'ils ont été codés en émission. Le démodulateur numérique 208 peut également comprendre un module de calcul du taux d'erreurs sur les symboles ou sur les bits reçus par comparaison avec les symboles ou les bits émis ou par un mécanisme intégré au décodeur.

L'organe de contrôle 212 peut être configuré pour sélectionner le type de modulation/démodulation numérique et/ou le type de codage/décodage des bits. En particulier l'organe de contrôle 212 peut déterminer le meilleur taux de codage à appliquer aux bits à transmettre en fonction de l'analyse du réflectogramme qui donne une indication sur l'état du canal de transmission.

L'organe de contrôle 212 peut aussi utiliser l'information de taux d'erreurs calculée par le décodeur pour déterminer les paramètres du codeur et du décodeur mais aussi pour sélectionner la fréquence de transposition. En effet, le taux d'erreurs donne une information sur le niveau de perturbation dans une bande de fréquence donnée. Ainsi, si le taux d'erreurs est trop élevé, par exemple supérieur à un seuil donné, l'organe de contrôle peut décider de sélectionner une autre bande de fréquence pour le signal.

Le système 200 selon ce mode de réalisation adapté à la communication peut permettre plusieurs communications simultanées sur différentes bandes de fréquences, en choisissant une fréquence de transposition différente pour chaque système dans le cas d'un réseau de câbles de communication comprenant plusieurs systèmes de communication 200 connectés à différents points du réseau. Ce cas de figure correspond à une application de transférométrie.

On décrit à présent un exemple particulier de réalisation du système selon l'invention associé à un signal de réflectométrie et de communication fréquentiel à multi-porteuses du type OFDM (Orthogonal Frequency Division Multiplexing). Cette technologie a notamment servi de base à l'élaboration de signaux particuliers utilisés en réflectométrie du type OMTDR (Orthogonal Multi-tone Time Domain Reflectometry) ou MCTDR (MultiCarrier Time Domain Reflectometry).

La figure 3 représente un schéma d'un système de réflectométrie et de transmission de données basé sur un signal de type OMTDR.

Le système décrit à la figure 3 comporte un modulateur numérique 301, ou un codeur de symboles, pour convertir une séquence de données binaires à émettre en symboles numériques complexes via une modulation de phase PSK ou une modulation d'amplitude QAM. Le signal complexe numérique ainsi formé est transmis à un multiplexeur série-parallèle 302 puis à un module de prétraitement 303 qui réalise une symétrie hermitienne des symboles et ajoute un temps de garde. Les symboles sont ensuite transmis à un module de transformée de Fourier inverse 304. En sortie de ce module, les symboles sont purement réels du fait de l'opération de prétraitement 303 réalisée avant la transformée de Fourier inverse 304. Un démultiplexeur 305 permet ensuite de sérialiser le signal numérique réel qui est envoyé à un convertisseur numérique-analogique 306 puis à un coupleur 307 pour être injecté dans une ligne de transmission.

Le système comporte également un coupleur 307 pour mesurer le signal réfléchi en un point de la ligne. Le signal mesuré subit les opérations inverses à celles effectuées en émission. Il est numérisé via un convertisseur analogique-numérique 308, puis multiplexé via un multiplexeur 311. Un module de transformée de Fourier directe 312 converti le signal dans le domaine fréquentiel, puis une opération de post-traitement 313 inverse de l'opération de prétraitement 303 réalisée à l'émission, est appliquée. Un démultiplexeur 314 permet de sérialiser le signal complexe numérique qui est ensuite démodulé via un démodulateur numérique 315 ou un décodeur de symboles.

L'analyse de défauts est effectuée sur un signal réel en réalisant une corrélation 309 entre le signal en entrée du convertisseur numérique-analogique 306 et le signal en sortie du convertisseur analogique-numérique 308. Un module d'analyse 310 permet de caractériser les défauts éventuels à partir du réflectogramme mesuré.

La figure 4 représente une évolution du système de la figure 3 auquel on a appliqué les principes de l'invention décrits à la figure 2.

Les éléments communs entre le système 400 de la figure 4 et le système 300 de la figure 3 sont identifiés avec la même référence numérique. De même, les éléments communs entre le système 400 de la figure 4 et le système 200 de la figure 2 sont également identifiés avec la même référence numérique.

L'invention appliquée au système de la figure 3 consiste ainsi à exploiter directement un signal complexe en sortie du module de transformée de Fourier inverse 304 au lieu d'un signal réel comme cela est le cas pour la figure 3. A cet effet, on supprime les modules de pré-traitement 303 et post-traitement 313 utilisés en vue de rendre le signal réel en sortie du module IFFT 304. De cette façon, les symboles de redondance insérés en entrée du module 304 peuvent être supprimés. La corrélation complexe 210 est réalisée entre le signal en entrée du convertisseur 306 et le signal en sortie du convertisseur 308. Pour optimiser la complexité de mise en oeuvre, en particulier le nombre d'opérations nécessaires, la corrélation 210 est réalisée en calculant la transformée de Fourier inverse du produit des transformées de Fourier directes de chacun des deux signaux x et x'. Ce calcul peut être illustré par la formule suivante :

$$c(t) = \int_{-\infty}^{\infty} x'(t+\tau) \cdot x^*(\tau) \mathrm{d}\tau = \mathsf{TF}^{-1}\left\{\mathsf{TF}\left\{x'(t)\right\} \cdot \mathsf{TF}\left\{x^*(t)\right\}\right\}$$

La figure 5 représente une variante de réalisation du système décrit à la figure 4. Dans cette variante, on utilise une implémentation systolique de la transformée de Fourier inverse 401 et directe 402 de sorte qu'il est possible de supprimer les multiplexeurs et démultiplexeurs 302,305,311,314.

En outre, le corrélateur 403 peut être simplifié en effectuant directement la transformée de Fourier inverse du produit des signaux prélevés respectivement en entrée du module IFFT 401 et en sortie du module FFT 402.

La figure 6 représente encore un schéma d'un système de détection de défauts selon une autre variante de réalisation de l'invention.

Selon cette variante, le système 200 décrit à la figure 2 est complété avec un détecteur de phase 602 et un correcteur de phase 603 qui ont pour but de corriger les erreurs de phase que le signal peut subir lors de sa propagation dans le câble et aussi de compenser les décalages de phase qui peuvent exister entre les oscillateurs locaux associés au modulateur IQ 204 et au démodulateur IQ 206. De même, si la fréquence de transposition est modifiée en cours de fonctionnement, la phase du signal peut être modifiée en réception. Un déphasage peut également apparaitre entre le signal injecté dans le câble et le signal mesuré du fait des opérations de translation en fréquence respectives opérées sur le signal injecté et sur le signal mesuré.

Le signal de réflectométrie transmis en bande de base est noté x(t). Le signal en sortie du modulateur IQ 204 réalisant une translation de fréquence vers la fréquence $f_0$ est noté $x_{rf}(t) = \Re\big(x(t)e^{j2\pi f_0 t}\big)$, où $\Re(\,)$ désigne la partie réelle d'un signal complexe.

Le signal $x_{rf}(t)$ est démodulé en sortie du démodulateur IQ 206. Si l'erreur de phase entre le modulateur 204 et le démodulateur 206 est égale à $\varphi_0$, et, en négligeant l'atténuation du canal entre transmetteur et récepteur, le signal en bande de base reçu est défini comme :

$$\mathbf{x'(t) = x(t)e^{j\varphi_0}\big(1 + e^{-j(2\pi\,2f_0 t)}\big)}$$

La composante fréquentielle en $2f_0$ est filtrée (filtre non représenté sur la figure 6 qui peut être intégré au démodulateur 206).

Le réflectogramme est obtenu à partir de la corrélation entre le signal reçu x'(t) et filtré et le signal injecté x(t), en calculant la corrélation complexe c(t) :

$$\mathbf{c(t) = \int_{\tau=-\infty}^{\infty} x'(t+\tau)x^*(\tau)d\tau = e^{j\varphi_0}\int_{\tau=-\infty}^{\infty} x(t+\tau)x^*(\tau)d\tau}$$

L'erreur de phase peut ainsi être directement extraite de la valeur c(t=0) du réflectogramme car pour t=0 le résultat de l'intégrale

$$\int_{\tau=-\infty}^{\infty}\mathbf{x(t+\tau)x^*(\tau)d\tau}\ \text{est réel. Ainsi c(t=0)= } e^{j\varphi_0}.$$

Ainsi, le système 600 décrit à la figure 6 comprend un détecteur de phase 602 apte à mesurer la valeur en t=0 du réflectogramme calculé en sortie du corrélateur 210. Un correcteur de phase 603 est ensuite appliqué au signal en sortie du convertisseur analogique-numérique 207 avant de calculer un nouveau réflectogramme.

Selon une variante, le détecteur de phase 602 peut intégrer un filtre de boucle afin de lisser les variations potentielles de l'erreur de phase et d'assurer une convergence du système.

Le correcteur de phase 603 peut être réalisé par un simple multiplieur complexe.

Le signal corrigé en sortie du correcteur de phase 603 peut ainsi être correctement démodulé ensuite pour récupérer les données binaires transmises via le signal.

Les différents composants du système selon l'invention peuvent être mis en oeuvre au moyen de technologie logicielle et/ou matérielle. En particulier, l'invention peut être implémentée totalement ou partiellement au moyen d'un processeur embarqué ou d'un dispositif spécifique. Le processeur peut être un processeur générique, un processeur spécifique, un circuit intégré propre à une application (connu aussi sous le nom anglais d'ASIC pour « Application-Specific Integrated Circuit ») ou un réseau de portes programmables in situ (connu aussi sous le nom anglais de FPGA pour « Field-Programmable Gate Array »). Le système selon l'invention peut utiliser un ou plusieurs circuits électroniques dédiés ou un circuit à usage général. La technique de l'invention peut se réaliser sur une machine de calcul reprogrammable (un processeur ou un micro contrôleur par exemple) exécutant un programme comprenant une séquence d'instructions, ou sur une machine de calcul dédiée (par exemple un ensemble de portes logiques comme un FPGA ou un ASIC, ou tout autre module matériel).

**Revendications**

1. Système (200,400,600) de réflectométrie pour l'analyse de défauts dans une ligne de transmission dans laquelle un signal complexe généré puis modulé a été injecté, ledit système comprenant :

   - un moyen (205) de mesure du signal complexe modulé se propageant dans la ligne de transmission,
   - un démodulateur (206) du signal mesuré apte à produire un signal complexe démodulé,
   - un corrélateur complexe (210,403) configuré pour corréler le signal complexe démodulé avec une copie du signal complexe généré, pour produire un premier réflectogramme temporel correspondant à la partie réelle de la corrélation complexe et un second réflectogramme temporel correspondant à la partie imaginaire de la corrélation complexe,
- un module d'analyse (211) conjointe du premier réflectogramme temporel et du second réflectogramme temporel pour identifier la présence de défauts dans la ligne de transmission.

2. Système (200,400,600) de réflectométrie selon la revendication 1 dans lequel le module d'analyse (211) est configuré pour déterminer un réflectogramme temporel unique à partir du module de la corrélation complexe.

3. Système (600) de réflectométrie selon l'une des revendications précédentes comprenant en outre un détecteur de phase (602) configuré pour mesurer la phase de la corrélation complexe à l'abscisse temporelle 0 et un correcteur de phase (603) configuré pour corriger le signal complexe démodulé de la phase mesurée par le détecteur de phase (602).

4. Système (200,400,600) de réflectométrie selon l'une des revendications précédentes comprenant en outre un générateur (201,202) de signal complexe, un modulateur (204) apte à moduler le signal complexe pour produire un signal modulé et un moyen (205) pour injecter le signal modulé en un point de la ligne de transmission.

5. Système (200,400,600) de réflectométrie selon la revendication 4 comprenant en outre :

   - un oscillateur local (213) apte à contrôler la fréquence du modulateur (204) pour réaliser une transposition en fréquence du signal et un oscillateur local (213) apte à contrôler la fréquence du démodulateur (206) pour réaliser une transposition du signal en bande de base,
   - un organe de contrôle (212) apte à contrôler la valeur d'une fréquence de transposition à laquelle le signal est transposé.

6. Système (200,400,600) de réflectométrie selon la revendication 5 dans lequel l'organe de contrôle (212) est configuré pour déterminer la valeur de la fréquence de transposition du signal en fonction d'au moins une analyse du premier réflectogramme temporel et/ou du second réflectogramme temporel.

7. Système de réflectométrie (200,400,600) selon la revendication 6 dans lequel l'analyse du premier réflectogramme temporel et/ou du second réflectogramme temporel porte sur une mesure du niveau d'atténuation du signal mesuré.

8. Système de réflectométrie (400) selon l'une des revendications 4 à 7 dans lequel le signal complexe généré est un signal fréquentiel à multi-porteuses, ledit système comprenant en outre à cet effet un module de transformée de Fourier inverse (304,401) appliqué au signal complexe généré et un module de transformée de Fourier (312,402) appliqué au signal complexe démodulé pour générer un signal fréquentiel démodulé.

9. Système de réflectométrie (400) selon la revendication 8 dans lequel le corrélateur complexe (403) comprend un corrélateur du signal fréquentiel généré avec le signal fréquentiel démodulé et une transformée de Fourier inverse appliquée au résultat de la corrélation.

10. Système de réflectométrie selon l'une des revendications 4 à 9 dans lequel le générateur de signal complexe comprend une interface (201) pour recevoir des données numériques à transmettre et un modulateur (202,301) pour convertir les données numériques en symboles complexes, ledit système comprenant en outre un récepteur (208,315) pour convertir le signal démodulé complexe en données numériques reçues.

11. Système de réflectométrie (200) selon la revendication 10 comprenant en outre un encodeur (202) des données numériques à transmettre et un décodeur (208) des données numériques reçues, l'organe de contrôle (212) étant configuré pour déterminer le taux de codage de l'encodeur et du décodeur.

12. Système de réflectométrie (200) selon la revendication 11 comprenant en outre un module de calcul du taux d'erreurs entre les données numériques décodées et les données numériques à transmettre, l'organe de contrôle (212) étant configuré pour déterminer la valeur de la fréquence de transposition du signal et/ou le taux de codage en fonction d'au moins le taux d'erreurs calculé.

**Patentansprüche**

1. Reflektometriesystem (200, 400, 600) für die Analyse von Fehlern in einer Übertragungsleitung, in die ein erzeugtes und dann moduliertes komplexes Signal eingespeist wurde, wobei das System Folgendes umfasst:

- ein Mittel (205) zum Messen des modulierten komplexen Signals, das sich in der Übertragungsleitung ausbreitet,
- einen Demodulator (206) für das gemessene Signal, der zum Produzieren eines demodulierten komplexen Signals ausgelegt ist,
- einen komplexen Korrelator (210, 403), der zum Korrelieren des demodulierten komplexen Signals mit einer Kopie des erzeugten komplexen Signals konfiguriert ist, um ein dem Realteil der komplexen Korrelation entsprechendes erstes zeitliches Reflektogramm und ein dem Imaginärteil der komplexen Korrelation entsprechendes zweites zeitliches Reflektogramm zu produzieren,
- ein Modul für die gemeinsame Analyse (211) des ersten zeitlichen Reflektogramms und des zweiten zeitlichen Reflektogramms, um das Vorhandensein von Fehlern in der Übertragungsleitung zu identifizieren.

2. Reflektometriesystem (200, 400, 600) nach Anspruch 1, wobei das Analysemodul (211) zum Bestimmen eines einzelnen zeitlichen Reflektogramms auf der Basis des Moduls für die komplexe Korrelation konfiguriert ist.

3. Reflektometriesystem (600) nach einem der vorherigen Ansprüche, das ferner einen zum Messen der Phase der komplexen Korrelation auf 0 der Zeitabszisse konfigurierten Phasendetektor (602) und einen Phasenkorrektor (603) umfasst, der zum Korrigieren des demodulierten komplexen Signals der vom Phasendetektor (602) gemessenen Phase konfiguriert ist.

4. Reflektometriesystem (200, 400, 600) nach einem der vorherigen Ansprüche, das ferner einen Komplexes-Signal-Generator (201, 202), einen Modulator (204), der das komplexe Signal zum Produzieren eines modulierten Signals modulieren kann, und ein Mittel (205) zum Einspeisen des modulierten Signals an einem Punkt der Übertragungsleitung umfasst.

5. Reflektometriesystem (200, 400, 600) nach Anspruch 4, das ferner Folgendes umfasst:

- einen Lokaloszillator (213), der die Frequenz des Modulators (204) zum Realisieren einer Frequenzumsetzung des Signals regeln kann, und einen Lokaloszillator (213), der die Frequenz des Demodulators (206) zum Realisieren einer Umsetzung des Signals in das Basisband regeln kann,
- ein Steuerorgan (212), das den Wert einer Umsetzungsfrequenz regeln kann, in die das Signal umgesetzt wird.

6. Reflektometriesystem (200, 400, 600) nach Anspruch 5, wobei das Steuerorgan (212) zum Bestimmen des Wertes der Umsetzungsfrequenz des Signals in Abhängigkeit von mindestens einer Analyse des ersten zeitlichen Reflektogramms und/oder des zweiten zeitlichen Reflektogramms konfiguriert ist.

7. Reflektometriesystem (200, 400, 600) nach Anspruch 6, wobei die Analyse des ersten zeitlichen Reflektogramms und/oder des zweiten zeitlichen Reflektogramms sich auf eine Messung der Dämpfung des gemessenen Signals bezieht.

8. Reflektometriesystem (400) nach einem der Ansprüche 4 bis 7, wobei das erzeugte komplexe Signal ein Mehrträger-Frequenzsignal ist, wobei das System zu diesem Zweck ferner ein Modul (304, 401) für eine auf das erzeugte komplexe Signal angewendete inverse Fourier-Transformation und ein Modul (312, 402) für eine auf das demodulierte komplexe Signal angewendete Fourier-Transformation umfasst, um ein demoduliertes Frequenzsignal zu erzeugen.

9. Reflektometriesystem (400) nach Anspruch 8, wobei der komplexe Korrelator (403) einen Korrelator des erzeugten Frequenzsignals mit dem demodulierten Frequenzdomänensignal und einer auf das Ergebnis der Korrelation angewendeten inversen Fouriertransformation umfasst.

10. Reflektometriesystem nach einem der Ansprüche 4 bis 9, wobei der Komplexes-Signal-Generator eine Schnittstelle (201) zum Empfangen von zu übertragenden digitalen Daten und einen Modulator (202, 301) zum Umwandeln der digitalen Daten in komplexe Symbole umfasst, wobei das System ferner einen Empfänger (208, 315) zum Umwandeln des komplexen demodulierten Signals in empfangene digitale Daten umfasst.

11. Reflektometriesystem (200) nach Anspruch 10, das ferner einen Encoder (202) für die zu übertragenden digitalen Daten und einen Decoder (208) für die empfangenen digitalen Daten umfasst, wobei das Steuerorgan (212) zum Bestimmen der Codierrate des Encoders und des Decoders konfiguriert ist.

12. Reflektometriesystem (200) nach Anspruch 11, das ferner ein Modul zum Berechnen der Fehlerrate zwischen den decodierten digitalen Daten und den zu übertragenden digitalen Daten umfasst, wobei das Steuerorgan (212) zum Bestimmen des Wertes der Umsetzungsfrequenz des Signals und/oder der Codierrate in Abhängigkeit von mindestens der berechneten Fehlerrate konfiguriert ist.


**Claims**

1. A reflectometry system (200,400,600) for the analysis of faults in a transmission line into which a complex signal, generated then modulated, has been injected, said system comprising:

   - a means (205) for measuring the modulated complex signal propagating in the transmission line,
   - a demodulator (206) of the measured signal able to produce a demodulated complex signal,
   - a complex correlator (210,403) configured for correlating the demodulated complex signal with a copy of the generated complex signal, in order to produce a first time-domain reflectogram corresponding to the real part of the complex correlation and a second time-domain reflectogram corresponding to the imaginary part of the complex correlation,
   - a module for joint analysis (211) of the first time-domain reflectogram and of the second time-domain reflectogram for identifying the presence of faults in the transmission line.

2. The reflectometry system (200,400,600) according to claim 1, wherein the analysis module (211) is configured for determining a single time-domain reflectogram from the complex correlation module.

3. The reflectometry system (600) according to one of the preceding claims, further comprising a phase detector (602) configured for measuring the phase of the complex correlation at the 0 of the time abscissa and a phase corrector (603) configured for correcting the demodulated complex signal of the phase measured by the phase detector (602).

4. The reflectometry system (200,400,600) according to one of the preceding claims, further comprising a complex signal generator (201,202), a modulator (204) able to modulate the complex signal for producing a modulated signal and a means (205) for injecting the modulated signal at one point of the transmission line.

5. The reflectometry system (200,400,600) according to claim 4, further comprising:

   - a local oscillator (213) able to control the frequency of the modulator (204) for performing a frequency transposition of the signal and a local oscillator (213) able to control the frequency of the demodulator (206) for performing a transposition of the signal into baseband,
   - a control mechanism (212) able to control the value of a transposition frequency at which the signal is transposed.

6. The reflectometry system (200,400,600) according to claim 5, wherein the control mechanism (212) is configured for determining the value of the transposition frequency of the signal as a function of at least one analysis of the first time-domain reflectogram and/or of the second time-domain reflectogram.

7. The reflectometry system (200,400,600) according to claim 6, wherein the analysis of the first time-domain reflectogram and/or of the second time-domain reflectogram relates to a measurement of the attenuation level of the measured signal.

8. The reflectometry system (400) according to one of claims 4 to 7, wherein the generated complex signal is a multi-carrier frequency-domain signal, said system further comprising, for this purpose, an inverse Fourier transform module (304,401) applied to the generated complex signal and a Fourier transform module (312,402) applied to the demodulated complex signal for generating a demodulated frequency-domain signal.

9. The reflectometry system (400) according to claim 8, wherein the complex correlator (403) comprises a correlator of the frequency-domain signal generated with the demodulated frequency-domain signal and an inverse Fourier transform applied to the result of the correlation.

**10.** The reflectometry system according to one of claims 4 to 9, wherein the complex signal generator comprises an interface (201) for receiving digital data to be transmitted and a modulator (202,301) for converting the digital data into complex symbols, said system further comprising a receiver (208,315) for converting the complex demodulated signal into received digital data.

**11.** The reflectometry system (200) according to claim 10, further comprising an encoder (202) of the digital data to be transmitted and a decoder (208) of the received digital data, the control mechanism (212) being configured for determining the coding rate of the encoder and of the decoder.

**12.** The reflectometry system (200) according to claim 11, further comprising a module for calculating the error rate between the decoded digital data and the digital data to be transmitted, the control mechanism (212) being configured for determining the value of the transposition frequency of the signal and/or the coding rate as a function of at least the calculated error rate.

FIG.1

FIG.2

FIG.2bis

FIG.3

FIG.4

couplage

modulateur IQ

démodulateur IQ

DAC

ADC

IFFT

FFT

IFFT

analyse

contrôle

modulateur

démodulateur

PSK/QAM

PSK/QAM

FIG.5

$f_{LO}$

FIG.6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2014144436 A
- WO 2015145068 A
- US 2016266194 A
- US 2016139194 A

**Littérature non-brevet citée dans la description**

- OMTDR using BER estimation for ambiguites cancellation in ramified networks diagnosis. **WAFA BEN HASSEN et al.** Intelligent Sensors, Sensor Networks and Information Processing. IEEE, 2013